# EUROPÄISCHE PATENTSCHRIFT

(11) **EP 1 535 315 B1**
(45) Veröffentlichungstag und Bekanntmachung des Hinweises auf die Patenterteilung: **24.11.2010**
(21) Anmeldenummer: 03775135.1
(22) Anmeldetag: 22.08.2003
(51) Int. Cl.: H01L 21/20, B81C 1/00, C03B 19/02, C03B 23/02

(54) **GLASARTIGES FLÄCHENSUBSTRAT, SEINE VERWENDUNG UND VERFAHREN ZU SEINER HERSTELLUNG**
GLASS-TYPE PLANAR SUBSTRATE, USE THEREOF, AND METHOD FOR THE PRODUCTION THEREOF
SUBSTRAT PLAT COMPOSE D'UN MATERIAU VITREUX, UTILISATION ET PROCEDE DE FABRICATION DE CELUI-CI

(30) Priorität: 06.09.2002 DE 10241390
(43) Veröffentlichungstag der Anmeldung: 01.06.2005
(73) Patentinhaber: Fraunhofer-Gesellschaft zur Förderung der angewandten Forschung e.V., 80686 München (DE)
(72) Erfinder: QUENZER, Hans-Joachim, 25524 Itzehoe (DE); SCHULZ, Arne, Veit, 22457 Hamburg (DE); MERZ, Peter, 25557 Beldorf (DE)
(74) Vertreter: Rösler, Uwe
(86) Internationale Anmeldenummer: PCT/EP2003/009328
(87) Internationale Veröffentlichungsnummer: WO 2004/030057

(56) Entgegenhaltungen:
- WO-A-99/01893
- WO-A-02/073684
- GB-A- 2 241 233
- US-A- 6 030 829

## Beschreibung

### Technisches Gebiet

Die Erfindung bezieht sich auf ein Verfahren zur Strukturierung eines aus glasartigem Material bestehenden Flächensubstrats.

### Stand der Technik

Glas oder glasartige Materialien als Werkstoff in der modernen Mikroelektronik oder Mikromechanik besitzen gegenüber anderen Materialien insbesondere Kunststoffe zahlreiche Vorteile hinsichtlich ihres mit Halbleitermaterialien vergleichbaren, geringen thermischen Ausdehnungskoeffizienten und verfügen darüber hinaus über eine große mechanische sowie auch chemische Stabilität, wodurch diese Materialien in vielen technischen Bereichen von großer Bedeutung sind.

Jedoch sind der Herstellung insbesondere von technisch sehr interessanten Produkten, insbesondere von mikromechanischen und mikroelektronischen Bauelementen aus Glas sehr enge Grenzen gesetzt, da bislang hinsichtlich der Mikrostrukturierung von Glas nur wenig geeigneten Ätzverfahren bekannt sind, so daß bislang lediglich mechanischen Verfahren wie Sägen, Schleifen, Polieren, Ritzen, Ultraschall oder Sandstrahlen zum Einsatz kommen. Dadurch sind die Strukturierungsmöglichkeiten von Glas stark eingeschränkt. Mit diesen konventionellen Bearbeitungstechniken ist jedoch eine Strukturierung von Glas in den Mikro- und insbesondere Submikrometerbereich nicht mit der in der HalbleiterBauelement-Technik geforderten Präzision möglich.

Aufgrund dieser stark eingeschränkten Strukturierungsmöglichkeiten werden Mikrostrukturkörper häufig aus Kunststoff gefertigt. So beschreibt bspw. die DE 43 07 869 A1 ein Verfahren, bei dem Mikrostrukturkörper aus Kunststoff oder Sinterwerkstoffen mittels eines Formeinsatzes abgeformt werden. Der mikrostrukturierte Formeinsatz wird hierbei aus einem festen Körper, der aus Metall, Keramik, Glas, Stein oder einkristallinem Material ist, durch feinmechanische Präzisionsbearbeitung, additive oder subtraktive Strukturierung hergestellt. Anschließend wird der Formeinsatz mit fließfähigem Material ausgefüllt, überdeckt und nach seiner Verfestigung wird das Material von dem Formeinsatz getrennt. Der so gefertigte Mikrostrukturkörper weist allerdings ebenfalls den Nachteil auf, dass er aus einem Material mit einem großen thermischen Ausdehnungskoeffizienten gefertigt ist und im Vergleich zu glasartigen Materialien über eine geringere mechanische und chemische Stabilität verfügt.

Könnten die technischen Grenzen in der Glasbearbeitung durchbrochen werden, so ließen sich neue Anwendungsgebiete erschließen, in denen Verbundwerkstoffe aus Silizium und Glas eine tragende Rolle spielen. Derartige Verbundelemente können sich die komplementären Eigenschaften beider Materialien zunutze machen. Zum Beispiel besitzt Glas im Vergleich zu Silizium eine sehr niedrige elektrische und thermische Leitfähigkeit, ist jedoch im Gegensatz zu Silizium im sichtbaren Wellenlängenbereich optisch transparent.

Zudem spielt neben Silizium Glas oder glasartige Materialien eine wichtige Rolle bei der Realisierung mikromechanischer Komponenten. Besonders im Hinblick auf eine Verkapseln der Bauelemente auf Waferlevel wird Glas als elektrisch isolierendes Material häufig eingesetzt. Aber auch in diesem Zusammenhang stößt man in der Mikrostrukturierung auf die vorstehend genannten Grenzen.

Zur Überwindung der vorstehend geschilderten Problematik ist in der nachveröffentlichten Druckschrift DE 101 18 529 vorgeschlagen worden - zu der im übrigen diese Anmeldeschrift als Zusatzanmeldung anzusehen ist -, ein zu strukturierendes glasartiges Flächenmaterial mit einem bereits vorstrukturierten, aus einem Halbleitermaterial bestehenden Flächensubstrat in Verbindung zu bringen, vorzugsweise im Wege eines anodischen Bondvorganges, und diese Kompositstruktur derart zu erwärmen, dass das glasartige Material seine Fließtemperatur überschreitet und auf diese Weise in die vorstrukturierten Vertiefungen innerhalb des Halbleiter-Flächenmaterials eindringt. Nach entsprechendem Tempern und nachfolgendem Erkalten der Kompositstruktur sind die strukturierten Vertiefungen innerhalb des Halbleitermaterials vorzugsweise vollständig mit dem glasartigen Material ausgefüllt. Nach entsprechender Nachbehandlung der erkalteten Kompositstruktur kann das Halbleitermaterial im Wege gezielter Materialabtragung von dem sich innerhalb der Vertiefungen befindlichen Glasmaterial getrennt werden, um letztlich die gewünschte strukturierte Komponente aus Glas oder glasartigen Material zu erhalten.

Ein wesentlicher Aspekt des in der vorstehenden Druckschrift vorgeschlagenen Verfahrens betrifft die Vorstrukturierung des Halbleiter-Flächensubstrates, die nicht nur maßgeblich für Größe, Form und Dimensionierung des letztlich zu erhaltenen strukturierten Glasproduktes verantwortlich ist, sondern auch entscheidend an den Verfahrens- und damit Herstellungskosten des gewünschten Produktes beiträgt.

In einem bevorzugten Ausführungsbeispiel, das auf der technischen Lehre der DE 101 18 529 beruht, wird ein als Siliziumsubstrat bzw. Si-Wafer ausgebildetes Halbleiter-Flächensubstrat mittels Ätzprozess strukturiert, vorzugsweise werden mit Hilfe eines Trockenätzprozesses gezielt Vertiefungen in den Si-Wafer eingebracht. Dadurch können zwar beliebige Konturen in den Siliziumwafer eingebracht werden, anderseits wirft der Einsatz von Trockenätztechniken jedoch vergleichsweise hohe Kosten auf. In bestimmten Fällen, z.B. bei der Herstellung von periodischen Stempelstrukturen, wäre jedoch eine Herstellung derartiger Strukturen mittels Einsägen auf einer Wafersäge eine deutlich billigerer Alternative, jedoch stossen derartige konventionelle Materialabtragetechniken auf folgendes Problem:

Um einen für den Eindringvorgang des erwärmten fließfähigen, glasartigen Materials in die Vertiefungen des Halbleiter-Flächensubstrats erforderlichen gasdichten Abschluss zwischen dem strukturierten Halbleiterwafer und dem glasartigen Flächensubstrat zu erhalten, erfolgt die Strukturierung des Si-Wafers unter Verwendung eines Ätzprozesses nicht bis zum Waferrand, dieser nämlich wird bewusst unstrukturiert belassen, gleichwohl eine nahezu vollständige Flächennutzung des Si- Wafers angestrebt wird. Bedient man sich hingegen zur Strukturierung des Si-Wafers der vergleichbar zum Ätzprozess deutlich günstigeren Säge- oder Frästechnik, so ist es nicht möglich den Rand des Wafers von der Strukturierung auszusparen, sofern man bestrebt ist die vorgegebene Waferfläche möglichst vollständig für die Strukturierung auszunutzen. Damit kann jedoch mit dem in der DE 101 18 529 beschriebenen Verfahren keine dichte Verbindung der beiden Substrate, z.B. durch das anodische Bonden des Glas mit dem Siliziumsubstrat, erreicht werden. Ein Vakuumeinschluß in den Kavitäten des Siliziumwafers ist damit ausgeschlossen, und somit wird ein vollständiges Auffüllen der Siliziumstrukturen während des Glasfließens verhindert.

Die GB 2 241 233 A zeigt ein Verfahren zur Herstellung von perforiertem Glas, bei dem ein Perforationsmittel, z.B. Stäbe aus Kupfer oder einem ätzbaren Material, in eine Glasschmelze gedrückt wird. Nach dem Abkühlen der Glasschmelze wird das Perforationsmittel mechanisch oder chemisch entfernt.

Die US 6 030 829 A offenbart ein Verfahren zur Herstellung von Trägern, die für biologische oder chemische Testverfahren oder zur Zellkultur eingesetzt werden und die in ihrer Oberfläche eine Vielzahl von Vertiefungen aufweisen. Zur Herstellung dieser Vertiefungen wird eine Art Stempel aus Metall, der entsprechend hervorstehende Strukturen aufweist, in ein thermoformbares Material gedrückt. Bei der Herstellung von Glasträgern wird das Glas soweit erwärmt, dass es plastisch formbar, aber nicht flüssig ist.

Die WO 99 01893 A offenbart ein Verfahren zur Herstellung von schichtartigen Gebilden, bei dem auf einem strukturierten, monokristallinen (dotierten) Si-Substrat eine poröse Materialschicht erzeugt wird. Auf der porösen Materialschicht werden epitaktisch weitere Halbleiterschichten aufgewachsen. Danach wird eine Glasabdeckscheibe aufgebracht. Das Schichtgebilde wird einer mechanischen Krafteinwirkung ausgesetzt, so dass sie an der, wie eine Sollbruchstelle wirkenden, porösen Schicht auseinander bricht.

### Darstellung der Erfindung

Der Erfindung liegt die Aufgabe zugrunde das in der DE 101 18 529 beschriebene Verfahren zur Strukturierung eines aus glasartigen Material bestehenden Flächensubstrats derart weiterzubilden, dass die Verfahrenskosten deutlich reduziert werden sollen. So soll es möglich sein den für die Vorstrukturierung des Halbleiter-Flächensubstrates erforderlichen Ätzprozess durch eine günstigere Strukturierungstechniken zu ersetzen. Zudem sollen alle Vorteile, die mit dem Verfahren gemäß der DE101 18 529 erzielbar sind, uneingeschränkt erhalten bleiben.

Die Lösung der der Erfindung zugrundeliegenden Aufgabe ist in dem Anspruch 1 angegeben. Gegenstand des Anspruchs 33 ist ein mit diesem Verfahren hergestelltes und strukturiertes glasartiges Flächensubstrats. Ferner werden bevorzugte Verwendungen der mit dem Verfahren herstellbaren Produkten angegeben. Gegenstand der Unteransprüche sowie der Beschreibung insbesondere unter Bezugnahme auf die Figuren betreffen den Erfindungsgedanken vorteilhaft weiterbildende Merkmale.

Das erfindungsgemäße Verfahren macht sich die gezielte und kostengünstige mechanische Materialabtragung im Wege der Säg-, Fräs- oder Schleiftechnik zu Eigen, um die Strukturierung des Halbleiter-Flächensubstrates vorzunehmen. Durch diesen Einsatz können nicht nur Halbleiteroberflächen in großen Stückzahlen, wie sie in der industriellen Fertigung vorkommen, kostengünstig hergestellt werden, auch ist es möglich Kleinserien, insbesondere in der Entwicklung, Forschung und Prototypenfertigung kostenreduziert zu verwirklichen.

Um das kostengünstige Strukturierungsverfahren in Verbindung mit der Herstellung strukturierter glasartiger oder Glassubstrate erfolgreich anwenden zu können, dient das nachstehende erfindungsgemäße Verfahren, das sich im einzelnen aus den folgenden Verfahrensschritten zusammensetzt:

Zunächst wird ein aus einem Halbleitermaterial bestehendes Halbleiter-Flächensubstrat, bspw. in Form eines Silizium-Wafers bereitgestellt.

Bevor das Halbleiter-Flächensubstrat strukturiert wird, erfolgt zunächst eine Dickenreduzierung des Halbleiter-Flächensubstrats innerhalb wenigstens eines Oberflächenbereiches. Grundsätzlich kann die Dickenreduzierung an einer beliebigen Stelle des Halbleiter-Flächensubstrates vorgenommen werden, doch ist eine Dickenreduzierung des Halbleiter-Flächensubstrates längs seines Randbereiches von Vorteil. In aller Regel steht der periphere Randbereich eines typischen Si-Wafers, der sich ca. 3 mm vom Umfangsrand des Wafers nach innen auf der Waferoberfläche erstreckt, nicht für eine funktionelle Prozessierung zur Verfügung, so dass eine gezielte Dickenreduzierung in eben jenen Randbereich, keine Nachteile in Bezug auf einen Flächenverlust für technisch wertvolle Prozessierungflächen nach sich zieht. Die Dickenreduzierung erfolgt in besonders vorteilhafter Weise längs des gesamten Umfangsrandes des Halbleiter-Flächensubstrates bzw. um beim speziellen Fall des Si-Wafers zu bleiben, längs des gesamten Waferrandes. Somit bleibt inmitten des Wafers ein erhabener, großflächiger Oberflächenbereich gegenüber dem dickenreduzierten Randbereich bestehen. Der erhabene Oberflächenbereich ist von einer Begrenzungsseitenfläche umgeben, die eben jene Höhe gegenüber des dickenreduzierten Randbereiches aufweist, die der Abtragetiefe entspricht, um die der Randbereich ausgedünnt bzw. dickenreduziert worden ist.

Die Dickenreduzierung erfolgt vorzugsweise mittels eines naßchemischen Ätzverfahrens, es ist jedoch auch möglich geeignete mechanische Materialabtrageverfahren, wie bspw. Schleifen einzusetzen.

Für das nachfolgende Strukturieren des unbehandelten, erhabenen Oberflächenbereiches spielt das Vorsehen des dickenreduzierten Randbereiches am peripheren Umfangsrand des Wafers eine besondere Rolle. So ist es nun möglich mit Hilfe eines geeigneten materialabtragenden Werkzeuges, bspw. einer Oberflächensäge oder eines Fräs- oder Schleifkopfes, vorzugsweise lineare Schnitte in den erhabenen Oberflächenbereich einzuarbeiten, indem das Werkzeug mit einer vorgebbaren Schnitttiefe, die sich maximal bis zur Ebene des dickenreduzierten Oberflächenbereiches erstreckt, lateral zur erhabenen Oberfläche bewegt wird und diese lokal abträgt. Somit entstehen durchgängige Vertiefungen, die sich von einer Seite der Begrenzungsseitenfläche des erhabenen Oberflächenbereiches zur gegenüberliegenden Seite bzw. zu einer anderen Stelle erstrecken. Bedient man sich bspw. linearer Sägewerkzeuge, so können linear innerhalb des erhabenen Oberflächenbereiches verlaufende Vertiefungen eingearbeitet werden, die parallel zueinander orientiert oder unter vorgebbaren Winkeln sich durchkreuzen und eine Art Gittermuster bilden. Auch können längs eines vorgebbaren Kurvenverlaufes Einschnitte in den erhabenen Oberflächenbereich eingearbeitet werden, indem maschinengeführte Fräsköpfe oder geeignete Schleifvorrichtungen mit der erhabenen Oberflächenbereich in Eingriff gebracht werden. Neben der nahezu beliebigen Wahl der Musterbildung, die sich durch die Strukturierung des erhabenen Oberflächenbereiches ergibt, ist es auch möglich die Breite mit der die einzelnen linienhaften Vertiefungen vorgenommen werden, beliebig einzustellen. Dies kann dadurch erreicht werden, indem bspw. das verwendete materialabtragende Werkzeug zweimal oder mehrmals linenversetzt eine längs einer Schnitttrajektorie verfahren wird. Jedoch gilt es neben dem vorstehend aufgezeigten Variantenreichtum an Strukturierungen die Strukturtiefe stets kleiner oder gleich zu wählen als der Dickenbetrag, um den der Randbereich ausgedünnt worden ist. Auf diese Weise wird insbesondere ein weiterer Materialabtrag in eben jenen Randbereich vermieden.

Im Anschluß an den vorstehend geschilderten Strukturierungsprozess wird die Oberfläche des strukturierten erhabenen Oberflächenbereich des Halbleiter-Flächensubstrats mit dem glasartigen Flächensubstrat derart in Verbindung gebracht, dass das glasartige Flächensubstrat zumindest teilweise den dickenreduzierten Oberflächenflächenbereich überdeckt. Eine alternative Verfahrensvariante sieht vor, den dickenreduzierten Oberflächenflächenbereich zu metallisieren bevor das glasartige Flächensubstrat aufgebracht wird. Dies hat besondere Vorteile zur Schaffung elektrisch leitender Durchführungen, auf die unter Bezugnahme auf die weitere Beschreibung noch eingegangen wird.

Vorzugsweise ist das glasartige Flächensubstrat derart bemessen, dass es das vorstrukturierte Halbleiter-Flächensubstrat vollständig überdeckt einschließlich den dickenreduzierten Randbereich. Zur festen und innigen Verbindung beider Flächensubstrate eignet sich besonders vorzugsweise das anodische Bonden sowie das thermische Bonden, sodass eine hermetisch dichte Verbindung zwischen beiden Flächensubstraten entsteht. Denkbar wäre auch ein bloßes Aufeinanderlegen beider Flächensubstrate, die bei entsprechender Konturdeckung durch sich ausbildende Oberflächenadhäsionskräfte ebenso in einem gewissen Rahmen gasdicht aneinander haften.

Die Technik des Anodischen Bondens führt jedoch zu einer hochqualitativen gasdichten Verbindung und ist bereits seit Ende der sechziger Jahre bekannt, bei der zwei hochplanare Substrate, in der Regel bestehend aus einem Metall- und einem Isolatorsubstrat auf einer sogenannten "Hot Plate" erhitzt. Im vorstehend beschriebenen Fall werden das Halbleiter- und das glasartige Flächensubstrat zusammengefügt. Zusätzlich wird eine Spannung zwischen beiden Flächensubstraten von bis zu 1000 V angelegt. Befindet sich der negative Pol am glasartigen Flächensubstrat, so wandern die in der Glasmatrix vorhandenen positiven, beweglichen Ionen in Richtung Kathode. Die unbeweglichen, und somit ortsfesten Sauerstoffionen bilden an der Grenze zum Halbleiter eine negative Raumladungszone. Zum einen führt die resultierende elektrostatische Kraft zu einem engen Kontakt der beiden Substratoberflächen. Zum anderen wird durch die starken elektrischen Felder an der Grenzfläche zwischen dem Halbleiter-Flächensubstrat, bspw. ein Siliziumwafer, und dem Glas eine elektrochemische Reaktion ausgelöst in deren Verlauf sich an der Grenzfläche ein Oxid ausbildet das beide Substrate miteinander verbindet.

Beim Anodischen Bonden von Si und Glas wird als glasartiges Flächensubstrat ein Borosilikatglas (PyrexTM, BorofloatTM) verwendet, das im thermischen Ausdehnungskoeffizient weitgehend an Silizium angepaßt ist. Allerdings werden bei diesem Verfahren die beiden scheibenförmig vorliegenden Materialien als vertikaler Verbund (einfach oder mehrfach) übereinandergestapelt.

Zu beachten ist jedoch, dass das Halbleiter- und das glasartige Flächensubstrat zwar längs der Oberfläche des strukturierten erhabenen Oberflächenbereichs innig und gasdicht miteinander verbunden sind, jedoch überragt das glasartige Flächensubstrat den dickenreduzierten Randbereich des Halbleiter-Flächensubstrats im Abstand der Höhe, um den der Randbereich dickenreduziert worden ist, sodass insbesondere in diesem Randbereich beide Flächensubstrate noch keine gasdichte innige Verbindung eingehen, die, wie sich noch zeigen wird, für die weiteren Verfahrensschritte wichtig und erforderlich ist.

In einem nachfolgenden Temperschritt, dem die vorstehend erläuterten, zusammengefügten Flächensubstrate unterzogen werden, erfolgt nun in einem ersten Temperschritt die vollständige gasdichte beiderseitige Versiegelung zwischen beiden Flächensubstraten. So wird das auf dem Halbleitersubstrat aufliegende und mit diesem in dessen erhabenen, strukturierten Oberflächenbereich verbundene glasartige Flächensubstrat unter Unterdruckbedingungen, vorzugsweise innerhalb eines Vakuumofen, derart getempert, bis die Fließemperatur des glasartigen Materials erreicht wird. In diesem Stadium beginnt sich bevorzugt der überhängende Randbereich des glasartigen Flächensubstrats abzusenken, um schließlich mit dem dickenreduzierten Randbereiches des Halbleiter-Flächensubstrates eine innige und gasdichte Verbindung einzugehen. Dabei umschließt das fließfähige, sich absenkende glasartige Material zugleich auch die Begrenzungsseitenfläche des erhabenen Oberflächenbereiches mit den darin eingebrachten Öffnungen zu den einzelnen Vertiefungen.

Der Absenkvorgang des Randbereiches des glasartigen Flächensubstrates kann vorzugsweise auch dadurch unterstützt und beschleunigt werden, indem zusätzlich zum Eigengewicht des überstehenden Glasrandes auf diesem eine Last, bspw. in Form eines ringförmig ausgebildeten Gewichtes, bestehend vorzugsweise aus Graphit, einwirkt.

Nachdem der Glassrand überall vollständig mit dem Rand des dickenreduzierten Halbleiter-Flächensubstrats in Kontakt gekommen ist und somit die Strukturen bzw. die Vertiefungen in dem Halbleiter-Flächensubstrat hermetisch dicht eingeschlossen sind, erfolgt eine zweite Temperung unter Normaldruck bzw. unter erhöhtem Druck. Damit wird ein vollständiges Auffüllen der Zwischenräume des Siliziumwafers durch das Glassubstrat erreicht.

Im Wege eines Ofenprozess, der unter Normalbedingungen erfolgt, füllt das auf den plastischen Bereich oberhalb der Glastemperatur T_{G} erhitzte Glasmaterial die Strukturöffnungen bzw. die Vertiefungen innerhalb des Halbleiter-Flächensubstrats vollständig aus. Nach entsprechendem Abkühlen beider innig miteinander verbundenen Flächensubstrate, deren thermisches Ausdehnungsverhalten vergleichbar oder gar identisch sind, wodurch nur geringe oder keine thermischen Spannungen auftreten, weist das glasartige Flächensubstrat die Struktur des Halbleiter-Flächensubstrats in der Negativform auf.

Anschließend wird die Oberfläche des glasartigen Flächensubstrats bis auf die vorstrukturierte Halbleiteroberfläche zurückgeschliffen und poliert, z.B. durch Chemisch-mechanisches Polieren, sodass bereits nach Vollendung dieses Bearbeitungsschrittes ein Verbund-Flächensubstrat erhalten wird, in dem Glas oder glasartiges Material mit Strukturdimensionen geformt ist, die bislang nur Halbleitermaterialien und allen voran einkristallines Silizium vorbehalten waren.

In weiteren vorteilhaften Bearbeitungsschritten wird nun die Rückseite des Halbleiter-Flächensubstrat bearbeitet, indem das überschüssige Halbleitermaterial, bspw. Silizium ebenfalls durch Schleifen und Polieren entfernt wird. Damit bleibt ein Substrat übrig, das in bestimmten Arealen aus Halbleitermaterial und in anderen aus dem glasartigen Material besteht.

Zusätzlich ist es möglich in einem weiteren Ätzprozess das Halbleitermaterial zu entfernen, um zum Beispiel sehr schmale Löcher oder Durchbrüche im Glassubstrat zu erhalten. Weitere mechanische Schleif- und Poliervorgänge können sich daran anschließen, um die Durchbrüche präzise zu öffnen bzw. entsprechende Öffnungskonturen zu erhalten.

Unter Ausnutzung der Fliesseigenschaft von Glas im erhitzten Zustand kann also die Oberflächentopographie von einem strukturierten Halbleiter-Flächensubstrats, bspw. in Form eines Siliziummasters, in glasartige Materialien exakt übertragen werden. Dadurch ergeben sich erhebliche Vorteile in der Fertigung und in Bezug auf die Präzision. So können die Vorteile der Siliziumtechnologie (exakte Formgebungsverfahren bis in den sub-µm-Bereich hinein, Vielfalt der Strukturierungsmöglichkeiten) sowie die guten Materialeigenschaften von Glas kombiniert werden.

Bei hinreichend großen Strukturhöhen im ursprünglichen Halbleiter-Flächensubstrats und kompletter Abformung in das glasartige Flächensubstrat durch einen geeigneten Glasfliessprozess, können damit Flächen erzeugt werden, die komplett durch das neue Verbundsubstrat hindurch reichen. Je nach der flächenmäßigen Verteilung können auf diese Weise Glaswafer mit Siliziumdurchführungen oder Siliziumwafer mit Glasfenster erzeugt werden.

Ein besonders wichtiger Aspekt hierbei ist die sehr gute thermische Verträglichkeit der verwendbaren Materialien, bspw. Silizium und Glas (Borosilikatgläser wie etwa Pyrex^{®}, Tempax^{®} oder Borofloat Glas). Aufgrund der fast perfekten Übereinstimmung der thermischen Ausdehnungskoeffizienten zwischen Silizium und Pyrexglas^{®} läßt sich gewissermaßen ein thermisch homogenes Substrat herstellen. Insbesondere treten dadurch keinerlei Effekte auf, die auf thermisch induzierten Streß zurückzuführen sind, wie etwa Neigung zu Rißbildung oder Verbiegung der Substrate.

Die Dicke beider Flächensubstrate liegt typischerweise zwischen 0.1 mm und 1 mm. Es wird an dieser Stelle betont werden, daß die laterale Geometrie der Segmentierung des Halbleiter- und glasartigen Flächensubstrats keiner prinzipiellen Einschränkung unterworfen ist. Die Bereiche unterschiedlicher Materialien können zusammenhängend oder nicht zusammenhängend sein.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnung exemplarisch beschrieben. Es zeigen:
- Fig. 1: Ablaufschema des erfindungsgemäßen Verfahrens zur Herstellung eines strukturierten glasartigen Flächensubstrates,
- Fig. 2: Draufsicht auf ein glasartiges Flächensubstrat mit elektrischen Durchführungen,
- Fig. 3a,b: Anwendungsbeispiele für ein prozessiertes glasartiges Flächensubstrat,
- Fig. 4: Draufsicht auf ein Halbleiter-Flächensubstrat mit isolierten elektrischen Durchführungen,
- Fig. 5: Ablaufschema eines alternativen Verfahrensablaufes sowie
- Fig. 6a,b: Darstellung eines Deckelwafers.

### Wege zur Ausführung der Erfindung, gewerbliche Verwendbarkeit

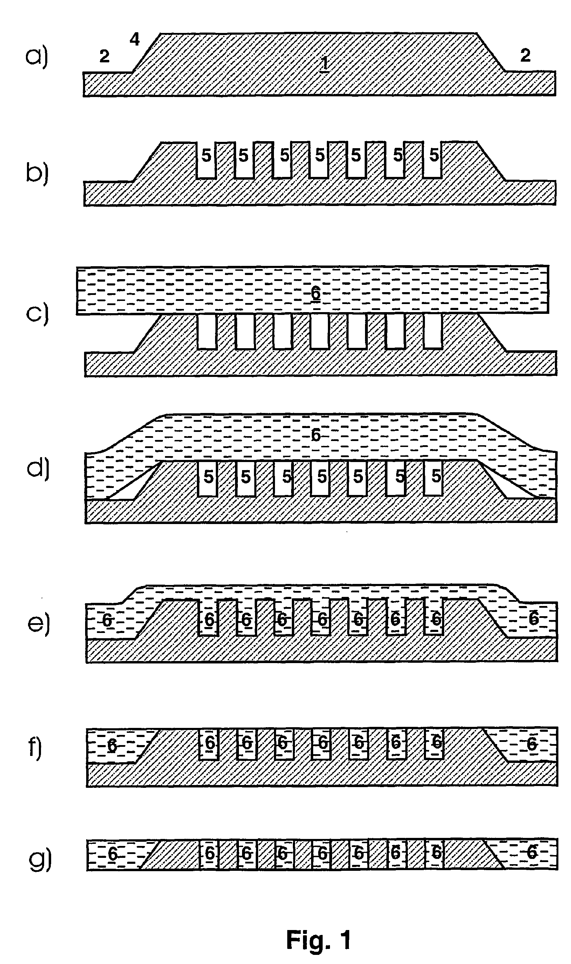

In den Figuren 1 a - g sind die erfindungsgemäßen Verfahrensschritte in schematisierter Abfolge dargestellt.

In Fig. 1 a wird zur Vorbereitung des Verfahrens das Halbleiter-Flächensubstrat 1 längs seines Randbereiches 2 dickenreduziert. Der dickenreduzierte Randbereich 2 weist bei einem als Si-Wafer ausgebildeten Halbleiter-Flächensubstrat eine Randbreite b von ca. bis zu 4 mm auf. Geht man typischerweise von einer Waferdicke von ca. 800 µm aus, so erfolgt ein Dickenabtrag im Randbereich 2 des Wafers von bis zu 500 µm, so dass im dickenreduzierten Randbereich 2 eine Waferrestdicke von ca. 400 µm übrig bleibt. Der erhabene Oberflächenbereich 3 des Wafers 1 ist durch eine Begrenzungsseitenfläche 4 umgeben, die senkrecht, oder wie im Falle der Figur 1 a. schräg gegenüber der Oberfläche des Randbereiches 2 angestellt ist.

Die Dickenreduzierung erfolgt vorzugsweise mittels naßchemischen Ätzverfahrens bspw. mittels KOH.

In Fig. 1b sind eine Vielzahl von Vertiefungen bzw. Einschnitte 5 in den erhabenen Oberflächenbereich eingebracht, die die Begrenzungsseitenfläche 4 offen durchragen. Die Einschnitte sind typischerweise durch Einsägen oder Einfräsen in den erhabenen Oberflächebereich 3 eingearbeitet. Wesentlich ist, dass die maximale Tiefe der Einschnitte 5 kleiner oder gleich der Ebene der dickenreduzierten Oberfläche ist.

In Figur 1c wird das glasartige Flächensubstrat 6 auf das bereits vorstrukturierte Halbleiter-Flächensubstrat 1 im Wege des anodischen Bondens innig verfügt. Hierbei schließen beide Flächensubstrate Zwischenvolumen ein, die durch die Geometrie der Vertiefungen 5 innerhalb der Oberfläche des Halbleiter-Flächensubstrates vorgegeben sind. Die Größe des glasartigen Flächensubstrates ist derart gewählt, dass der Randbereich des glasartigen Flächensubstrates 6 den dickenreduzierten Randbereich 2 überdeckt. Alternativ zum anodischen Bonden, das typischerweise bei Temperaturen von ca. 400 - 500 °C durchgeführt wird und bei dem zwischen den zu verbindenden Oberflächen eine elektrische Spannung angelegt wird, eignet sich auch das thermische Bonden zum Verbinden des glasartigen Flächensubstrats mit dem vorstrukturierten Halbleiter-Flächensubstrat, bei dem die zu verbindenden Flächensubstrate bei Temperaturen von ca. 1000 °C und unter Druck miteinander verfügt werden. Das thermische Bonden erfordert zwar höhere Temperaturen, jedoch sind die Anforderungen an die Planheit der zu verbindenden Oberflächen nicht so hoch wie beim anodischen Bonden.

In vorteilhafter Weise erfolgt nun unter Unterdruckbedingungen gem. Fig. 1d ein Tempervorgang, bei dem das glasartige Material über die Glastemperatur in den plastischen Bereich bzw. in den fließfähigen Zustand überführt wird. Hierbei senkt sich der Randbereich des glasartigen Flächensubstrates und neigt sich auf die Oberfläche des dickenreduzierten Randbereiches 2 und schließt mit dieser eine gasfesten Zusammenschluss ein.

Im weiteren wird gemäß Fig. 1e der Tempervorgang unter Normal- oder Überdruckbedingungen fortgeführt, wodurch sich das glasartige Material des Flächensubstrates in die Vertiefungen 5 vollständig absankt. Die treibende Kraft, mit der das plastische Glasmaterial in die Strukturöffnungen hineingetrieben wird, ist zwar grundsätzlich das innerhalb der Strukturöffnungen eingeschlossene Vakuum, doch kann der Vorgang durch etwaig vorhandene Überdruckbedingungen innerhalb des Temperofens unterstützt werden. Bei konstanter Temperatur und entsprechender Prozesszeit haben jedoch die Materialeigenschaften des glasartigen Flächensubstrates den entscheidenden Einfluss auf die Ausprägung und Genauigkeit der Strukturabformung.

Nach entsprechendem Erkalten beider nun innig miteinander verzahnten Flächensubstrate erfolgt ein Materialabtrag mittels geeigneter Schleif- und/oder Polierprozessen. Je nach späterer Verwendungsweise kann gemäß Fig. 1f das glasartige Flächensubstrat von oben in der Weise abgetragen werden, so dass das glasartige Flächensubstrat bündig mit der strukturierten Oberfläche des Halbleiter-Flächensubstrates abschließt.

Fig. 1g zeigt schließlich das Ergebnis eines weiteren Materialabtrageprozesses, der die über die strukturierten Bereiche hinausstehenden, entsprechenden Flächensubstratanteile (siehe hierzu Fig. 1c, 1d) beseitigt. In diesem Stadium wird ein feinst strukturiertes glasartiges Flächensubstrat erhalten, das vollständig mit einer Vielzahl von Halbleiter-Durchbrüchen durchsetzt ist. Nach entsprechendem Materialabtrag des an der Unterseite befindlichen, überstehenden Halbleitermaterials gemäß Figur 1g wird eine Verbundkomponente erhalten, wie nachstehend erläutert wird, die zur selektiven elektrischen Kontaktierung von mikroelektronischen Bauelementen dient.

Alternativ ist es auch möglich, beide Flächensubstrate beispielsweise nach vollendeter Abkühlung im Anschluss an den Tempervorgang voneinander zu trennen, indem eine geeignete Trennschicht zwischen beiden Flächensubstraten eingebracht wird. So ist es insbesondere möglich, dass durch Aufbringen geeigneter Trennschichten eine Wiederverwendung des vorstrukturierten Halbleiter-Flächensubstrates möglich ist, wodurch die Verfahrenskosten weiter reduziert werden können. Hierzu ist es erforderlich, dass vor dem Verbinden beider Flächensubstrate eine oder mehrere Trennschichten zwischen beiden Flächensubstraten eingebracht werden. Prinzipiell gibt es hierzu mehrere Möglichkeiten:
a) Auf dem Halbleiter-Flächensubstrat, bspw. Si-Wafer, wird eine Kohlenstoffschicht oder Diamantschicht oder diamantähnliche Schicht oder SiC aufgebracht, die ein Ankleben des Glases am Silizium unterbindet. Die Verbindung des Si-Wafers mit dem Glaswafer wird durch einen Ring aus einem Lot erreicht, der die beiden Wafer am Waferrand vakuumdicht verbindet. Zwar wird das Lot bei der Prozesstemperatur bei der das Glasfließen stattfindet flüssig, die schlechte Benetzung der unbeschichteten Glas bzw. Kohlenstoffschichten verhindert jedoch, daß das Lot zu weit zwischen die Wafer eindringen kann. Die Trennung der beiden Wafer kann entweder rein mechanisch erfolgen, der Lotring kann auch durch Ätzen entfernt werden oder aber die Kohlenstoffschicht wird durch einen Oxidationsprozess (ca. 400 - 500°C unter Sauerstoff) zwischen den beiden Substraten abgetragen. Vor einen weiteren Einsatz des Siliziumwafers müssen diese Schichten unter Umständen diese Trennschicht erneut aufgetragen werden.
b) Auf dem Si-Wafer wird eine Haftvermittlungsschicht aus einem geeigneten Metall aufgebracht z.B. Tantal. Auf dieser Schicht wird ein weiteres Metall aufgebracht, z.B. Zinn. Zinn verhindert ebenfalls ein Ankleben des Glases am Silizium und ist während des Glasfließprozesses flüssig Die Trennung der beiden Wafer kann entweder während eines weiteren Temperschritt oberhalb des Schmelzpunkts von Zinn rein mechanisch erfolgen oder aber das Metall wird selektiv zum Silizium und Glas herausgeätzt.
c) Auf dem Siliziumwafer wird eine zweite Schicht aufgebracht, mit der direkt der Glaswafer verbunden werden kann (z.B. durch anodic bonding). Beispiele hierfür wären Silizium, Titan, Aluminium oder Tantal. Am Ende des gesamten Prozesses wird diese Opferschicht durch Ätzen selektiv zum Glas oder Silizium entfernt. Um zu vermeiden, dass der ursprüngliche Si-Wafer angegriffen wird, kann der Wafer auch mit geeigneten Schichten versehen werden, z.B. Siliziumnitrid oder Siliziumcarbid.

Mit den geeigneten Trennschichten kann der Herstellungsprozess so abgewandelt werden, daß der Siliziumwafer mehrfach eingesetzt werden kann. Unter Umständen müssen die Trennschichten vor einem erneuten Einsatz wieder aufgebracht werden. Der nach dem Abtrennen des Siliziumwafers erhaltene strukturierte Glaswafer muß schließlich nur noch auf der Rückseite abgeschliffen werden, um komplette Durchbrüche zu erhalten. Diese Durchbrüche können in einem weiteren Prozeß z.B. galvanisch mit Metallen aufgefüllt werden

Im allgemeinen erfolgt in der Mikroelektronik und Mikrosystemtechnik die elektrische Kontaktierung von Chips über am Rand der Chips liegende Pads. In einer Reihe von Anwendungsfällen ist dies jedoch nachteilhaft und daher nicht gewünscht. Beispielsweise
- aus elektrischen Gründen, um Signalverluste zu reduzieren, z.B. bei kleinen kapazitiven Signalen oder bei HF-Signalen. Die elektrische Durchführung bietet einen geringeren Serienwiderstand, geringere Streukapazitäten und geringere Induktivitäten als die Kontaktierung über den Rand.
- aus Platzgründen. Dies gilt insbesondere für Systeme, die nahtlos arrayförmig aus mehreren Chips zusammengesetzt werden müssen, z.B. großflächige Detektorenarrays oder Mikrospiegelarrays. In diesen Fällen muß bei den inneren Chips auf den Padbereich verzichtet werden. Aber auch bei Einzelbauelementen gibt es oftmals Platzprobleme, z.B. bei medizinischen Mikrosonden (Elektroden zur Stimulation oder Registrierung).
- wenn mehrere funktionale Chips übereinandergestapelt werden und einen Stack bilden. Beispielsweise kann die oberste Ebene aus Sensoren (z.B. optische) bestehen und in dem Chip darunter die Signalverarbeitungselektronik liegen.
- Probe-Cards bestehen aus Mikrokontaktarrays zum automatisierten elektrischen Test von Chips, Wafern oder Leiterplatten. In diesem Fall ist aus elektrischen Gründen, bei größeren Probe-Cards auch aus Platzgründen eine Durchkontaktierung gewünscht.

In eben jenen Fällen ist eine Durchkontaktierung durch den Chip eine Alternative, die mit einem erfindungsgemäß prozessierten Glassubstrat möglich ist.

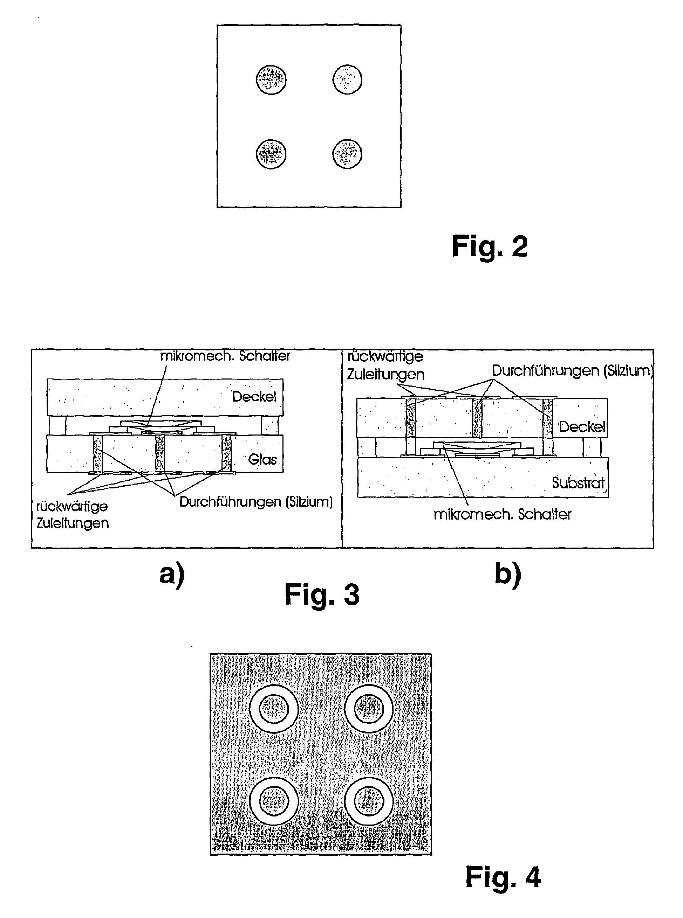

Figur 2 zeigt eine schematisierte Draufsicht auf ein prozessierten Glaswafer (weißer Bereich), der mit elektrischen Kontakten (schwarze Bereiche) durchsetzt ist. Eine derartige Struktur ist im Verfahrensschritt gemäß der Figur 1g erhältlich. Die elektrischen Kontakte durch den Glaswafer können aus hochleitendem Silizium (Verfahren ohne Trennschicht) oder aus Metallen bestehen (Verfahren mit Trennschicht und nachfolgendem Aufmetallisieren der freien Durchbrüche innerhalb des Glaswafers).

Besonders vorteilhaft erscheint die Verwendung derartig strukturierter Substrate für den Aufbau mikromechanischer Komponenten für den Hochfrequenzbereich 1- 100 GHz. Ein konkretes Beispiel hierzu ist der Figur 3 a) und b) zu entnehmen. In diesem Beispiel wird auf einem Glassubstrates mit elektrischen Durchführungen ein mikromechanisches Bauelement (mirkomechanischer Schalter) aufgebaut (Fig. 3a). Am Ende des gesamten Herstellungsablaufs wird die gesamte Struktur hermetisch mit einem Deckelwafer im Wege eines Lötprozesses verkappt, wobei auch die elektrischen Kontakte zwischen beiden Wafern hergestellt werden. Alternativ können die elektrischen Kontakte auch in den Deckel eingebracht werden (Fig. 3b).

Auch dienen die in Figur 2 dargestellten elektrischen Kontaktbereiche der gezielten Wärmeabführung. Einsatzbereiche sind denkbar bei Anwendungen, bei denen in einem Glassubstrat in bestimmten Bereichen Wärme abgeführt werden muß. Die Silizium- oder Metalldurchführungen dienen hier also als Wärmeleitpfade.

In Figur 4 ist ein Ausführungsbeispiel für ein Siliziumwafer (schwarze Bereiche) dargestellt, der zu Zwecken isolierter elektrischer Durchführungen ringförmige Glasbereiche (weiße Bereiche) aufweist. Eine derartige Struktur kann auch in etwas abgewandelter Form im Rahmen des Verfahrensschrittes gemäß Figur 1g erhalten werden. Derartige Siliziumwafer, bei denen in bestimmten Bereichen aus elektrischen, thermischen oder optischen Gründen Glas eingearbeitet sind, eignen sich für eine Vielzahl unterschiedlicher Anwendungsfälle:

### - Siliziumwafer mit thermisch isolierten Bereichen

Für diese Anwendungen sind die Strukturen nach den Figuren 1f oder 1g geeignet. Thermisch isolierte Bereiche auf Siliziumwafern sind insbesondere bei thermischen Sensoren erforderlich, zum Beispiel bei Thermopiles, Bolometern oder pyroelektrischen Sensoren. Für diese Sensortypen werden bislang Membranstrukturen im oder auf dem Chip erzeugt, um die thermische Isolation zu gewährleisten. Diese Sensoren sind jedoch aus Stabilitätsgründen nicht für Einsatzbereiche mit hoher mechanischer Belastung geeignet.

### - Siliziumwafer mit optischen Fenstern

Hierzu können die Strukturen gemäß der Figuren 1f oder 1g eingesetzt werden. Einsatzmöglichkeiten sind z.B. Lichtkollimatoren mit spezifischer Formgebung oder Kollimatorarrays mit engen Öffnungen.

### - Siliziumwafer mit elektrisch isolierten Bereichen

Hierzu sind ebenfalls die Strukturen gemäß der Figuren 1f oder 1g nutzbar. Auf den Glasbereichen können insbesondere passive HF-Bauelemente (z.B. Induktivitäten) oder MEMS-Bauelemente mit hoher Güte platziert werden. Auf reinen Siliziumsubstraten können aufgrund der Verluste im Substrat keine hohen Güten erreicht werden.

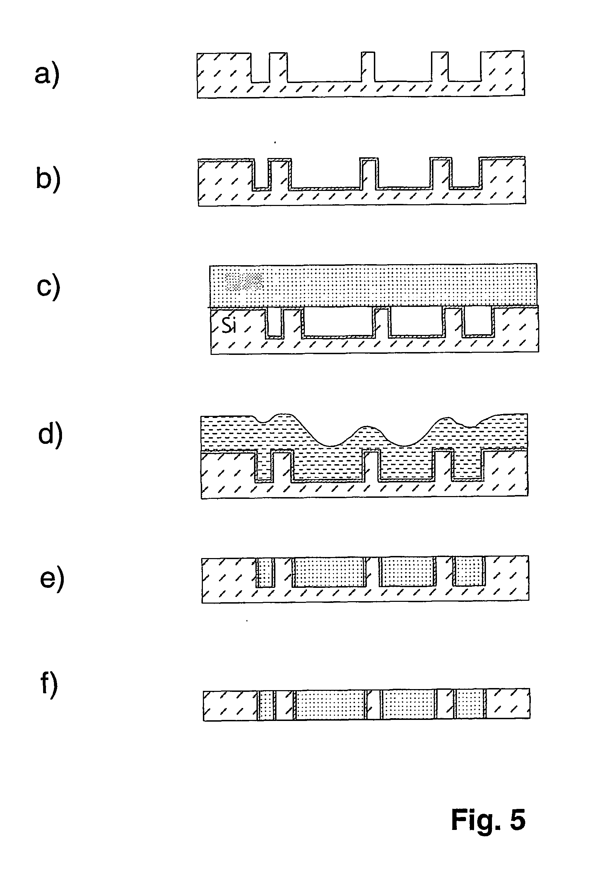

Zur Herstellung derartiger Siliziumwafer, die über elektrisch leitende Verbindungsstrukturen verfügen, die den Siliziumwafer senkrecht durchsetzen, sei zur Illustration auf die Figur 5 verwiesen, in der in schematischer Abfolge bevorzugte Teilprozessschritte gezeigt sind:

Nach Abschluß einer Strukturierung eines Siliziumsubstrates, das in Schritt a schräg schraffiert ist, wie auch in den folgenden Prozessschritten, die vorzugsweise in gleicher Weise wie im Teilverfahrensschritt gemäß Figur 1b durchgeführt wird, wird in einem darauffolgenden Schritt (b) eine zusätzliche Metallschicht (siehe dünn schraffierter Schicht) möglichst strukturkonform auf das strukturierte Siliziumsubstrat aufgebracht. Die Metallabscheidung kann mit an sich bekannten Verfahrensrechniken bspw. im Wege eines Abscheideporzesses durch Bedampfen erfolgen. Eine zusätzliche Schutz- oder Barriereschicht zwischen dem Siliziumsubstrat und der Metallschicht kann optional zuvor aufgebracht werden, z.B. in Form einer thermischen SiO₂-Schicht. Hierdurch können Reaktionen zwischen dem Silizium und dem Metall vermieden werden.

Nach Verbinden der Glaswafers (siehe gepunktete Schicht) mit dem metallisierten Substrat unter Vakuumbedingungen (Prozessschritt c) erfolgt das Auffüllen der zwischen dem Glaswafer und dem Siliziumsubstrat eingeschlossenen Kavitäten durch Hineinfließen des Glases im Wege eines Tempervorganges, wie eingangs beschrieben (d). Das überstehende Glasmaterial bzw. das Silizium wird schließlich durch Schleifen und Polieren auf beiden Seiten des Siliziumsubstrats entfernt (siehe Prozessschritte e und f). Dabei werden ebenfalls die metallisierten Bereiche auf bzw. zwischen den sich ergebenden Siliziumdurchführungen bzw. Siliziumstegen entfernt. Übrig bleiben Siliziumareale (Siliziumstifte) die durch eine dünne Metallschicht verstärkt und wiederum von Glas umgeben sind. Ziel ist es die vergleichsweise schlechte elektrische Leitfähigkeit reiner Siliziumdurchführungen hierdurch deutlich zu verbessern. Auf diese Weise können Anschlussstrukturen für mikrosystemtechnische Systeme einfach und günstig hergestellt werden.

Generell ist die Herstellung hermetisch dichter Verbindungen bereits auf Waferebene ein sehr wichtiges Thema in der Mikrosystemtechnik. Bewegliche Mikrostrukturen müssen in jedem Fall gegen widrige Umweltbedingungen geschützt werden, am besten noch auf Waferebene. Neben den Kostenaspekten die für eine Verkapselung auf Waferebene sprechen, spielt vor allem ein Schutz gegenüber den notwendigen Vereinzelungsprozessen eine sehr wichtige Rolle. Da zudem häufig eine hermetisch dichte Versiegelung erforderlich ist, ergibt sich zwangsläufig das Problem der elektrischen Durchführungen unterhalb der Versiegelungsflächen. In diesem Zusammenhang die Verkapselung von mikroelektronischen Bauelementen betreffend unterstützt das erfindungsgemäße Verfahren die CSP-Technologie (Chip Side Packaging).

Im Falle der Siliziumsensoren haben sich Verfahren auf der Basis von Glasloten bewährt, allerdings werden dabei Prozesstemperaturen von ca. 400°C benötigt, eindeutig zu hoch etwa für metallische Mikroelemente. Zudem eignen sich Verbindungstechniken auf der Basis von Glasloten nur zum Versiegeln über eine vergleichsweise niedrige Topographie (ca. 0.5µm).

Hermetisch dichte Verbindungen bei Temperaturen unterhalb 250 - 300°C lassen sich anderseits durch Löten herstellen. Hier ergibt sich allerdings zwangsläufig das Problem, daß die Zuleitungen bei den zur Verfügung stehenden Isolationsmaterialien und deren prozesstechnisch herstellbaren Schichtdicken stark miteinander kapazitiv gekoppelt sind. Daher scheiden solche Durchführungen für die Herstellung von mikromechanischen Bauelementen für hohen Frequenzen eigentlich aus. Nur durch die Verwendung von Durchführungen durch das Substrat oder den Deckel hindurch ist eine ausreichende Trennung der Leitungen möglich.

Neben den bereits genannten Aspekten spricht für die Herstellung von Durchführungen auch die verbesserte Handhabung des kompletten Chips. Insbesondere eignen sich solcherart aufgebaute Bauelemente auch für die Nutzung innerhalb von Flip-chip Prozessen oder sogar der Verwendung des Chips direkt in der Leiterplattenbestückung z.B. als SMD Bauteil.

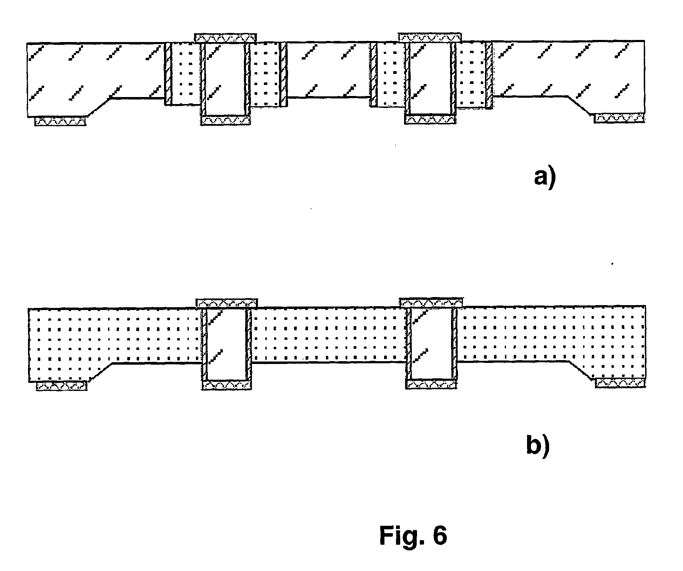

In den Figuren 6 a und b sind mögliche Ausführungsbeispiele für ein Deckelelement gezeigt, die mit dem vorstehenden Verfahren herstellbar sind und eine Nutzung der Durchführungen zum hermetisch dichten Verkappen bereits auf Waferebene ermöglichen. Das Verkappen auf Waferebene erlaubt das gleichzeitige Versiegeln zahlreicher Bauteile und ist deswegen besonders kostengünstig.

In diesem Beispiel werden aufbauend auf den beschriebenen Herstellungsprozessen von kombinierten Glas-Siliziumsubstraten zwei Deckelwafer beschrieben, die aus großen Teilen Siliziums bestehen. Wieder gilt die Konvention, dass schraffierte Bereiche Halbleiterbereiche, vorzugsweise Si, darstellen, gepunktete Bereiche Glasbereiche und die dünnen, schraffierten Schichtbereiche elektrisch leitende Bereiche, bspw. Gold, darstellen.

Die Durchführungen aus Silizium - je nach Erfordernisse zusätzlich mit einem Metall umhüllt oder auch nicht - sind vom Rest des Substrates durch einen breiten Ring aus Glas getrennt, der typischerweise eine Dicke von 50- 200 µm aufweist. Nach Fertigstellung des kombinierten Glas-Silizumsubstrates werden in zusätzlichen Bearbeitungsschritten eine Grube in die Vorderseite des Substrates hineingeätzt, um Platz für eine zu kapselnde Sensorstruktur zu schaffen, und Durchführungen mit einem Metall, vorzugsweise Gold sowohl auf der Ober- als auch der Unterseite beschichtet. Zusätzlich werden die begrenzenden Areale der Chips mit einer ringförmigen Metallschicht versehen (kann unter Umständen die gleiche Metallisierung der Kontakte sein Beispiel: Gold).

Der so aufgebaute Deckelwafer kann anschließend auf einen Sensorchip gebondet bzw. gelötet werden, auf den in diesem Zusammenhang nicht weiter eingegangen wird. Üblicherweise werden heute jedoch zwei Chips mittels Drahtbonden verbunden. Da die hierfür notwendigen Verbindungsdrähte, die sogenannten bond loops, nicht immer die gleiche Geometrie aufweisen, variieren die dadurch induzierten parasitären Kapazitäten und Induktivtäten von Chip zu Chip und begrenzen schlußendlich die Auflösungsgrenzen der gesamten Sensoren. Dem gegenüber ist eine Flip-chip Montage eines Sensors bspw. auf einen ASIC unter Verwendung des beschriebenen Deckelwafers geradezu ideal, zumal die Verbindungen nicht nur immer in ihrer Geometrie identisch sind, sondern auch noch besonders kurz.

Ferner sei darauf hingewiesen, dass das erfindungsgemäße Verfahren die Parallel-Herstellung von einer Vielzahl von einzelnen strukturierten glasartigen Flächensubstrate ermöglicht, die überdies im Rahmen eines Batch-Verfahrens produziert werden können, wodurch sich das Verfahren auch unter den Gesichtspunkten der industriellen Massenfertigung hervorragend eignet.

## Patentansprüche

1. Verfahren zur Strukturierung eines aus glasartigem Material bestehenden Flächensubstrats (6),
**gekennzeichnet durch** die Kombination folgender Verfahrensschritte:
- Bereitstellen eines aus einem Halbleitermaterial bestehenden Halbleiter-Flächensubstrats (1),
- Dickenreduzieren des Halbleiter-Flächensubstrats (1) innerhalb wenigstens eines Oberflächenbereiches (2) des Halbleiter-Flächensubstrates (1) zur Ausbildung eines gegenüber des dickenreduzierten Oberflächenflächenbereiches (2) erhabenen Oberflächenbereiches (3),
- Strukturieren des erhabenen Oberflächenbereiches (3) des Halbleiter-Flächensubstrats (1) mittels lokalen mechanischem Materialabtrag, zum Einbringen von Vertiefungen (5) innerhalb des erhabenen Oberflächenbereiches (3),
- Verbinden der strukturierten Oberfläche des Halbleiter-Flächensubstrats (1) mit dem glasartigen Flächensubstrat (6) derart, dass das glasartige Flächensubstrat (6) zumindest teilweise den dickenreduzierten Oberflächenflächenbereich (2) überdeckt,
- Tempern der verbundenen Flächensubstrate derart, dass in einer ersten Temperphase, die unter Unterdruckbedingungen durchgeführt wird, das den dickenreduzierten Oberflächenbereich (2) überdeckende glasartige Flächensubstrat (6) mit dem dickenreduzierten Oberflächenbereich (2) eine fluiddichte Verbindung eingeht, wobei das Flächensubstrat (6) die Vertiefungen unter Unterdruckbedingungen fluiddicht überdeckt, und dass in einer zweiten Temperphase ein Hineinfließen wenigstens von Teilbereichen des glasartigen Materials in die Vertiefungen (5) der strukturierten Oberfläche des Halbleiter-Flächensubstrats (1) erfolgt.

2. Verfahren nach Anspruch 1,
**dadurch gekennzeichnet, dass** nach dem Strukturieren des erhabenen Oberflächenbereiches (3) des Halbleiter-Flächensubstrats (1) und vor dem Verbinden der strukturierten Oberfläche des Halbleiter-Flächensubstrats (1) mit dem glasartigen Flächensubstrat (6) ein strukturkonformes Abscheiden einer Metallschicht auf dem strukturierten, erhabenen Oberflächenbereich erfolgt.

3. Verfahren nach Anspruch 1 oder 2,
**dadurch gekennzeichnet, dass** die Dickenreduzierung am Randbereich des Halbleiter-Flächensubstrats (1) durchgeführt wird.

4. Verfahren nach Anspruch 3,
**dadurch gekennzeichnet, dass** die Dickenreduzierung derart durchgeführt wird, dass der erhabene Oberflächenbereich (3) von einer Begrenzungsfläche (4) begrenzt und vom dickenreduzierten Randbereich (2) zumindest teilweise umgeben wird.

5. Verfahren nach Anspruch 3 oder 4,
**dadurch gekennzeichnet, dass** die Dickenreduzierung im Wege eines naßchemischen Ätzverfahrens oder eines mechanischen Materialbearbeitungsverfahren durchgeführt wird.

6. Verfahren nach einem der Ansprüche 1 bis 5,
**dadurch gekennzeichnet, dass** das Strukturieren des erhabenen Oberflächenbereiches (3) des Halbleiter-Flächensubstrats (1) mittels lokalen mechanischem Materialabtrag derart erfolgt, dass mittels eines Abtragewerkzeuges Vertiefungen (5) innerhalb des erhabenen Oberflächenbereiches (3) eingearbeitet werden, die eine Strukturtiefe aufweisen, die sich maximal bis zur Ebene der dickenreduzierten Oberflächenbereich erstreckt.

7. Verfahren nach einem der Ansprüche 1 bis 6,
**dadurch gekennzeichnet, dass** als Abtragewerkzeug ein Säg-, Schleif- oder Fräswerkzeug verwendet wird.

8. Verfahren nach Anspruch 6 oder 7,
**dadurch gekennzeichnet, dass** das Abtragewerkzeug relativ zum Halbleiter-Flächensubstrat (1) derart bewegt wird, dass das Abtragewerkzeug lateral über die Oberfläche des dickenreduzierten Oberflächenbereiches (2) in den erhabenen Oberflächenbereich (3) zum gezielten Materialabtrag verfahren wird.

9. Verfahren nach einem der Ansprüche 1 bis 8,
**dadurch gekennzeichnet, dass** der Materialabtrag zu geradlinig oder gekrümmt verlaufenden Vertiefungskanälen innerhalb des erhabenen Oberflächenbereiches (3) führt.

10. Verfahren nach Anspruch 9,
**dadurch gekennzeichnet, dass** die Vertiefungskanäle zur Oberfläche des erhabenen Oberflächenbereiches (3) geöffnet sind und die seitliche Begrenzungswand (4) des erhabenen Oberflächenbereich offen durchragen.

11. Verfahren nach einem der Ansprüche 1 bis 10,
**dadurch gekennzeichnet, dass** das Verbinden des glasartigen Flächensubstrat (1) mit dem strukturierten Flächensubstrat mittels anodischem oder thermischen Bondens erfolgt.

12. Verfahren einem der Ansprüche 1 bis 11,
**dadurch gekennzeichnet, dass** während der zweiten Temperphase Normal- oder Überdruckbedingungen vorherrschen, die auf die vom Halbleiter-Flächensubstrat (1) abgewandte Oberfläche des glasartigen Flächensubstrats (6) einwirken.

13. Verfahren nach einem der Ansprüche 1 bis 12,
**dadurch gekennzeichnet, dass** das Tempern durch Steuerung von Temperatur und Zeitdauer derart ausgeführt wird, dass das Hineinfließen des glasartigen Materials in die Vertiefungen (5) des Halbleiter-Flächensubstrats (1) beendet wird, wenn das glasartigen Material die Vertiefungen (5) vollständig ausfüllt.

14. Verfahren nach einem der Ansprüche 1 bis 13,
**dadurch gekennzeichnet, dass** nach dem Tempern ein flächiger Materialabtrag derart durchgeführt wird, dass das glasartige Flächensubstrat (6) eine bündig zur strukturierten Oberfläche des Halbleiter-Flächensubstrats (1) anschließende Oberfläche annimmt.

15. Verfahren nach einem der Ansprüche 1 bis 14,
**dadurch gekennzeichnet, dass** an der Oberfläche des Halbleiter-Flächensubstrats (1), die der mit dem glasartigen Flächensubstrat (6) verbundenen Oberfläche gegenüberliegt, Halbleitermaterial abgetragen wird, bis zumindest Teilbereiche des in die Vertiefungen (5) hineingeflossenen glasartigen Materials freigelegt sind, die bündig mit der Oberfläche des Halbleiter-Flächensubstrats (1) abschließen.

16. Verfahren nach einem der Ansprüche 1, 3 bis 15,
**dadurch gekennzeichnet, dass** das Halbleitermaterial vom glasartigen Flächensubstrat (6) abgetrennt wird.

17. Verfahren nach Anspruch 16,
**dadurch gekennzeichnet, dass** das Abtrennen des glasartigen Flächensubstrats (6) vom Halbleiter-Flächensubstrat (1) durch Wegätzen des Halbleitermaterials erfolgt.

18. Verfahren nach Anspruch 16,
**dadurch gekennzeichnet, dass** das Abtrennen beider Flächensubstrate voneinander durch Vorsehen einer Trennschicht zwischen beiden Flächensubstraten erfolgt.

19. Verfahren nach Anspruch 18,
**dadurch gekennzeichnet, dass** die Trennschicht vor dem Zusammenführen beider Flächensubstrate auf der strukturierten Oberfläche des Halbleiter-Flächensubstrats (1) strukturerhaltend aufgebracht wird und als Opferschicht ausgebildet ist, die im Wege thermischer und/oder chemischer Einwirkung zerstört wird und ein Trennen beider Substrate voneinander ermöglicht.

20. Verfahren nach Anspruch 18 oder 19,
**dadurch gekennzeichnet, dass** als Trennschicht eine Metallschicht eingesetzt wird, die einen Schmelzpunkt aufweist, der unterhalb der Schmelzpunkte der Substrate liegt.

21. Verfahren nach Anspruch 18 oder 19,
**dadurch gekennzeichnet, dass** als Trennschicht eine oxidationsfähige Schicht eingesetzt wird, die sich unter Zufuhr von Sauerstoff und/oder thermischer Energie chemisch umwandelt.

22. Verfahren nach Anspruch 18 oder 19,
**dadurch gekennzeichnet, dass** als Trennschicht eine Kohlenstoffschicht, Diamantschicht, diamantähnliche Schicht oder SiC eingesetzt wird.

23. Verfahren nach einem der Ansprüche 16 bis 22,
**dadurch gekennzeichnet, dass** nach dem Abtrennen beider Flächensubstrate voneinander das glasartige Flächensubstrat (6) mechanisch nachbearbeitet wird, zum Erhalt von das Flächensubstrat senkrecht durchsetzende Durchbrüche.

24. Verfahren nach Anspruch 23,
**dadurch gekennzeichnet, dass** die Durchbrüche mit einem elektrisch leitfähigem Material aufgefüllt werden.

25. Verfahren nach einem der Ansprüche 2 bis 15,
**dadurch gekennzeichnet, dass** vor dem strukturkonformen Abscheiden der Metallschicht auf dem strukturierten erhabenen Oberflächenbereich eine Schutzschicht auf das Halbleiter-Flächensubstrat (1) zur Vermeidung von Reaktionen zwischen dem Halbleiter-Flächensubstrat (1) und der Metallschicht abgeschieden wird.

26. Verfahren nach einem der Ansprüche 2 bis 15 oder 25,
**dadurch gekennzeichnet, dass** vor dem Verbinden der strukturierten, metallisierten Oberfläche mit dem glasartigen Flächensubstrat (6) wenigstens Teilbereiche der metallisierten Oberfläche abgetragen werden.

27. Verfahren nach einem der Ansprüche 1 bis 26,
**dadurch gekennzeichnet, dass** das glasartige Material und das Halbleitermaterial über nahezu die gleichen thermischen Ausdehnungskoeffizienten verfügen.

28. Verfahren nach einem der Ansprüche 1 bis 27,
**dadurch gekennzeichnet, dass** das aus einem glasartigen Material bestehende Flächensubstrat (6) ein Bor-Silikat-Glas ist.

29. Verfahren nach einem der Ansprüche 1 bis 28,
**dadurch gekennzeichnet, dass** das Halbleiter-Flächensubstrat (1) ein Siliziumsubstrat ist.

30. Verfahren nach Anspruch 25 und 29,
**dadurch gekennzeichnet, dass** als Schutzschicht thermisches SiO₂ abgeschieden wird.

31. Verfahren nach einem der Ansprüche 1 bis 30,
**dadurch gekennzeichnet, dass** das Strukturieren des Halbleiter-Flächensubstrats (1) zu Vertiefungen (5) mit Strukturdimensionen im Mikro- und/oder sub-Mikrometer-Bereich führt.

32. Verfahren nach einem der Ansprüche 1 bis 31,
**dadurch gekennzeichnet, dass** die Vertiefungen (5) ein Aspektverhältnis (Höhe bzw. Tiefe:Breite) von 10:1 aufweisen.

33. Glasartiges Flächensubstrat, hergestellt nach einem Verfahren nach den Ansprüchen 1 bis 32,
**dadurch gekennzeichnet, dass** das glasartige Flächensubstrat (6) senkrecht zur Substratoberfläche von Durchbrüchen durchsetzt ist, in denen elektrisch leitfähiges Material vorgesehen ist.

34. Glasartiges Flächensubstrat nach Anspruch 33,
**dadurch gekennzeichnet, dass** die mit elektrisch leitfähigen Material gefüllten Durchbrüche arrayförmig angeordnet sind.

35. Verwendung des glasartigen Flächensubstrats nach Anspruch 33 oder 34 zur elektrischen Kontaktierung von Bauelementen aus der Mikroelektronik oder Mikromechanik.

36. Verfahren nach einem der Ansprüche 1 bis 15 oder 25 bis 32,
**dadurch gekennzeichnet, dass** ein mit einem glasartigen Material durchsetztes Halbleiter-Flächensubstrat hergestellt wird.

37. Halbleiter-Flächensubstrat, hergestellt mit einem Verfahren nach Anspruch 36, **dadurch gekennzeichnet, dass** das Halbleiter-Flächensubstrat (1) ein Siliziumwafer ist, der zu Zwecken der elektrischen und/oder thermischen Isolation oder aus Gründen
optischer Transparenz den Siliziumwafer zumindest teilweise durchsetzende glasartige Materialbereiche aufweist.

38. Halbleiter-Flächensubstrat nach Anspruch 37,
**dadurch gekennzeichnet, dass** die den Siliziumwafer zumindest teilweise durchsetzenden glasartigen Materialbereiche wenigstens einen Halbleiterbereich umschließen, und
dass zumindest zwischen dem umschlossenen Halbleiterbereich und den glasartigen Materialbereichen eine Metallschicht vorgesehen ist.

39. Halbleiter-Flächensubstrat nach Anspruch 38,
**dadurch gekennzeichnet, dass** der umschlossene Halbleiterbereich beidseitig jeweils mit einer Elektrodenstruktur bedeckt ist, die jeweils die den Halbleiterbereich umschließende Metallschicht kontaktieren.

## Claims

1. A method for structuring a planar substrate (6) made of a glass-type material,
**characterised by** the combination of the following process steps:
- provision of a planar semiconductor substrate (1) made of a semiconductor material,
- reduction in the thickness of the planar semiconductor substrate (1) within at least one surface area (2) of the planar semiconductor substrate (1) to form a raised surface area (3) relative to the surface area having a reduced thickness (2),
- structuring of the raised surface area (3) of the planar semiconductor substrate (1) by locally removing material in a mechanical manner, for the introduction of recesses (5) within the raised surface area (3),
- connection of the structured surface of the planar semiconductor substrate (1) to the glass-type planar substrate (6), in such a way that the glass-type planar substrate (6) at least partly covers the surface area having a reduced thickness (2),
- tempering of the connected planar substrates, in such a way that in a first tempering phase, which is carried out under negative pressure conditions, the glass-type planar substrate (6) covering the surface area having a reduced thickness (2) forms a fluid-tight connection with the surface having a reduced thickness (2), wherein the planar substrate (6) covers the recesses in a fluid-tight manner under negative pressure conditions and that in a second tempering phase, at least partial areas of the glass-type material flow into the recesses (5) of the structured surface of the planar semiconductor substrate (1).

2. The method according to claim 1,
**characterised in that** following the structuring of the raised surface area (3) of the planar semiconductor substrate (1) and prior to the connection of the structured surface of the planar semiconductor substrate (1) to the glass-type planar substrate (6), a structurally-consistent metal layer is deposited on the structured, raised surface area.

3. The method according to claim 1 or 2,
**characterised in that** the reduction in thickness is carried out at the edge area of the planar semiconductor substrate (1).

4. The method according to claim 3,
**characterised in that** the reduction in thickness is carried out in such a way that the raised surface area (3) is limited by a peripheral area (4) and at least partially surrounded by the edge area having the reduced thickness (2).

5. The method according to claim 3 or 4,
**characterised in that** the reduction in thickness is achieved by means of a wet chemical etching process or a mechanical material working process.

6. The method according to one of the claims 1 to 5,
**characterised in that** the raised surface area (3) of the planar semiconductor substrate (1) is structured by means of local mechanical material removal, in such a way that recesses (5) are made in the raised surface area (3) using a removal tool, said recesses displaying a structural depth that extends no further than the plane of the surface area having a reduced thickness.

7. The method according to one of the claims 1 to 6,
**characterised in that** a sawing, grinding or milling tool is used for material removal.

8. The method according to claim 6 or 7,
**characterised in that** the material removal tool is moved relative to the planar semiconductor substrate (1) in such a way that the material removal tool is moved laterally over the surface of the surface area having the reduced thickness (2) in the raised surface area (3) for selective material removal.

9. The method according to one of the claims 1 to 8,
**characterised in that** the material removal results in recess channels within the raised surface area (3) running in a straight line or distorted.

10. The method according to claim 9,
**characterised in that** the recess channels are open to the surface of the raised surface area (3) and protrude through the side peripheral wall (4) of the raised surface area.

11. The method according to one of the claims 1 to 10,
**characterised in that** the connection of the glass-type planar substrate (1) to the structured planar substrate is made by means of anodic or thermal bonding.

12. The method according to one of the claims 1 to 11,
**characterised in that** during the second tempering phase normal or excess pressure conditions prevail, which act on the surface of the glass-type planar substrate (6) which is turned away from the planar semiconductor substrate (1).

13. The method according to one of the claims 1 to 12,
**characterised in that** the tempering is carried out by controlling the temperature and duration, so that the flow of the glass-type material into the recesses (5) of the planar semiconductor substrate (1) is ended when the glass-type material has completely filled the recesses (5).

14. The method according to one of the claims 1 to 13,
**characterised in that** after tempering, a planar material removal is carried out in such a way that the glass-type planar substrate (6) assumes an adjacent surface flush to the structured surface of the planar semiconductor substrate (1).

15. The method according to one of the claims 1 to 14,
**characterised in that** at the surface of the planar semiconductor substrate (1), which lies opposite the surface connected to the glass-type planar substrate (6), semiconductor material is removed, until at least partial areas of the glass-type material flowing into the recesses (5) are exposed, which end flush with the surface of the planar semiconductor substrate (1).

16. The method according to one of the claims 1, 3 to 15,
**characterised in that** the semiconductor material is separated from the glass-type planar substrate (6).

17. The method according to claim 16,
**characterised in that** the glass-type planar substrate (6) is separated from the planar semiconductor substrate (1) by etching away the semiconductor material.

18. The method according to claim 16,
**characterised in that** the two planar substrates are separated from one another by providing a separating layer between the two planar substrates.

19. The method according to claim 18,
**characterised in that** the separating layer is applied to the structured surface of the planar semiconductor substrate (1) in a structure-preserving manner before the two planar substrates are brought together and takes the shape of a sacrificial layer, which is destroyed under thermal and/or chemical action and enables the two substrates to be separated from one another.

20. The method according to claim 18 or 19,
**characterised in that** a metal layer is used as the separating layer, which has a melting point below the melting point of the substrates.

21. The method according to claim 18 or 19,
**characterised in that** a layer capable of oxidation is used as the separating layer, which is chemically converted through the supply of oxygen and/or thermal energy.

22. The method according to claim 18 or 19,
**characterised in that** a carbon layer, diamond layer, diamond-like layer or SiC is used as the separating layer.

23. The method according to one of the claims 16 to 22,
**characterised in that** once the two planar substrates have been separated from one another, the glass-type planar substrate (6) is mechanically reworked, in order to produce through-holes that penetrate the planar substrate vertically.

24. The method according to claim 23,
**characterised in that** the through-holes are filled with an electro-conductive material.

25. The method according to one of the claims 2 to 15,
**characterised in that** prior to the structurally-consistent deposition of the metal layer on the raised, a protective layer is deposited on the planar semiconductor substrate (1) to prevent reactions between the planar semiconductor substrate (1) and the metal layer.

26. The method according to one of the claims 2 to 15 or 25,
**characterised in that** prior to connection of the structured, metallised surface with the glass-type planar substrate (6), at least partial areas of the metallised surface are removed.

27. The method according to one of the claims 1 to 26,
**characterised in that** the glass-type material and the semiconductor material have virtually the same thermal expansion coefficients.

28. The method according to one of the claims 1 to 27,
**characterised in that** the planar substrate (6) made of a glass-type material is a boron-silicate glass.

29. The method according to one of the claims 1 to 28,
**characterised in that** the planar semiconductor substrate (1) is a silicon substrate.

30. The method according to claims 25 and 29,
**characterised in that** thermal SiO₂ is deposited as the protective layer.

31. The method according to one of the claims 1 to 30,
**characterised in that** the structuring of the planar semiconductor substrate (1) leads to recesses (5) with structural dimensions in the micro- and/or sub-micrometer range.

32. The method according to one of the claims 1 to 31,
**characterised in that** the recesses (5) display an aspect ratio (height or depth : width) of 10:1.

33. A glass-type planar substrate made using a method according to claims 1 to 32,
**characterised in that** the glass-type planar substrate (6) is penetrated by through-holes running vertically to the substrate surface, in which electro-conductive material is provided.

34. The glass-type planar substrate according to claim 33,
**characterised in that** the through-holes filled with electro-conductive material are disposed in an array configuration.

35. The use of the glass-type planar substrate according to claim 33 or 34 for the electrical contacting of components from microelectronics or micromechanics.

36. The method according to one of the claims 1 to 15 or 25 to 32,
**characterised in that** a planar semiconductor substrate penetrated by a glass-type material is produced.

37. A planar semiconductor substrate, made using a method according to claim 36,
**characterised in that** the planar semiconductor substrate (1) is a silicon wafer, which for the purposes of electrical and/or thermal insulation or for reasons
of optical transparency displays glass-type material areas at least partially penetrating the silicon wafer.

38. The planar semiconductor substrate according to claim 37,
**characterised in that** the glass-type material areas at least partially penetrating the silicon wafer enclose at least a semiconductor area and
that a metal layer is provided at least between the enclosed semiconductor area and the glass-type material areas.

39. The planar semiconductor substrate according to claim 38,
**characterised in that** the enclosed semiconductor area is covered on both sides with an electrode structure, each of which is in contact with the metal layer enclosing the semiconductor area.

## Revendications

1. Procédé de structuration d'un substrat plan (6) constitué d'un matériau vitreux,
**caractérisé par** la combinaison des étapes de procédé suivantes :
- mise à disposition d'un substrat plan semi-conducteur (1) constitué d'un matériau semi-conducteur,
- amincissement dudit substrat plan semi-conducteur (1) dans au moins une zone de surface (2) dudit substrat plan semi-conducteur (1) afin de former une zone de surface (3) faisant saillie par rapport à ladite zone de surface amincie (2),
- structuration de ladite zone de surface (3) faisant saillie au sein dudit substrat plan semi-conducteur (1), par l'enlèvement mécanique local de matière pour ainsi créer des cavités (5) au sein de ladite zone de surface (3) faisant saillie,
- liaison de la surface structurée dudit substrat plan semi-conducteur (1) avec ledit substrat plan vitreux (6), de façon à ce que ledit substrat plan vitreux (6) recouvre au moins partiellement ladite zone de surface amincie (2),
- trempe desdits substrats plans liés, de façon à créer, dans une première phase de trempe réalisée à une pression inférieure à la pression atmosphérique, une liaison étanche aux fluides entre ledit substrat plan vitreux (6) recouvrant ladite zone de surface amincie (2) et ladite zone de surface amincie (2) même, ledit substrat plan (6) venant, à une pression inférieure à la pression atmosphérique, recouvrir lesdites cavités en faisant l'étanchéité aux fluides, et de façon à ce que, dans une deuxième phase de trempe, au moins dans une partie des zones, ledit matériau vitreux vienne couler dans lesdites cavités (5) de ladite surface structurée dudit substrat plan semi-conducteur (1).

2. Procédé selon la revendication 1,
**caractérisé en ce que**, suite à la structuration de ladite zone de surface (3) faisant saillie au sein dudit substrat plan semi-conducteur (1) et avant de lier ladite surface structurée dudit substrat plan semi-conducteur (1) audit substrat plan vitreux (6), on dépose une couche métallique sur ladite zone de surface structurée et faisant saillie, de façon à ce qu'elle se conforme à ladite structure.

3. Procédé selon les revendications 1 ou 2,
**caractérisé en ce que** ledit amincissement est réalisé dans la zone marginale dudit substrat plan semi-conducteur (1).

4. Procédé selon la revendication 3,
**caractérisé en ce que** ledit amincissement est réalisé de façon à ce que ladite zone de surface (3) faisant saillie soit limitée par une surface de limitation (4) est au moins partiellement entourée par ladite zone marginale amincie (2).

5. Procédé selon les revendications 3 ou 4,
**caractérisé en ce que** ledit amincissement est réalisé par un procédé de gravure chimique humide ou par un procédé mécanique de travail de la matière.

6. Procédé selon l'une des revendications 1 à 5,
**caractérisé en ce que** ladite structuration de ladite zone de surface (3) faisant saillie au sein dudit substrat plan semi-conducteur (1), par l'enlèvement mécanique local de matière, est réalisée à façon créer, au moyen d'un outil d'enlèvement, des cavités (5) au sein de ladite zone de surface (3) faisant saillie, lesdites cavités présentant une profondeur de structure s'étendant au maximum jusqu'au niveau de ladite zone de surface amincie.

7. Procédé selon l'une des revendications 1 à 6,
**caractérisé en ce que** l'on utilise, en tant qu'outil d'enlèvement, un outil de sciage, de rectification ou de fraisage. ,

8. Procédé selon les revendications 6 ou 7,
**caractérisé en ce que** l'on fait progresser ledit outil d'enlèvement par rapport audit substrat plan semi-conducteur (1) de façon à ce que ledit outil d'enlèvement se déplace latéralement à travers la surface de ladite zone de surface amincie (2) en direction de ladite zone de surface (3) faisant saillie afin d'y réaliser de façon ciblée un enlèvement de matière.

9. Procédé selon l'une des revendications 1 à 8,
**caractérisé en ce que** ledit enlèvement de matière conduit à la création de canaux creux d'orientation rectiligne ou courbée au sein de ladite zone de surface (3) faisant saillie.

10. Procédé selon la revendication 9,
**caractérisé en ce que** lesdits canaux creux s'ouvrent vers la surface de ladite zone de surface (3) faisant saillie et se maintiennent ouvertement à travers la paroi latérale (4) limitant ladite zone de surface faisant saillie.

11. Procédé selon l'une des revendications 1 à 10,
**caractérisé en ce que** ladite liaison entre ledit substrat plan vitreux (1) et ledit substrat plan structuré est réalisée au moyen d'un procédé de soudure anodique ou thermique.

12. Procédé selon l'une des revendications 1 à 11,
**caractérisé en ce que**, pendant ladite deuxième phase de trempe, la face du substrat plan vitreux (6) opposée audit substrat plan semi-conducteur (1) est exposée à des pressions égales ou supérieures à la pression atmosphérique.

13. Procédé selon l'une des revendications 1 à 12,
**caractérisé en ce que** ladite trempe est réalisée en contrôlant la température et la durée de façon à ce que la coulée du matériau vitreux dans lesdites cavités (5) dudit substrat plan semi-conducteur (1) soit arrêtée lorsque ledit matériau vitreux remplit entièrement lesdites cavités (5).

14. Procédé selon l'une des revendications 1 à 13,
**caractérisé en ce que**, suite à la trempe, on réalise un enlèvement de matière en surface de façon à ce que ledit substrat plan vitreux (6) vienne constituer une surface arrivant au ras de ladite surface structurée dudit substrat plan semi-conducteur (1).

15. Procédé selon l'une des revendications 1 à 14,
**caractérisé en ce que**, sur la face du substrat plan semi-conducteur (1) opposée à la face liée avec ledit substrat plan vitreux (6), on enlève du matériau semi-conducteur jusqu'à ce que, au moins dans les zones où le matériau vitreux ayant coulé dans lesdites cavités (5) se trouve au ras dudit substrat plan semi-conducteur (1), ledit matériau vitreux soit mis à nu.

16. Procédé selon l'une des revendications 1, 3 à 15,
**caractérisé en ce que** ledit matériau semi-conducteur est séparé dudit substrat plan vitreux (6).

17. Procédé selon la revendication 16,
**caractérisé en ce que** ledit substrat plan vitreux (6) est séparé du substrat plan semi-conducteur (1) en enlevant le matériau semi-conducteur par gravure chimique.

18. Procédé selon la revendication 16,
**caractérisé en ce que** les deux substrats plans sont séparés l'un de l'autre en prévoyant une couche de séparation entre les deux substrats plans.

19. Procédé selon la revendication 18,
**caractérisé en ce que** ladite couche de séparation est appliquée, préalablement à l'assemblage des deux substrats plans, sur la surface structurée dudit substrat plan semi-conducteur (1) de façon à en conserver la structure et que ladite couche est destinée à être sacrifiée par voie thermique et/ou par des agents chimiques et qu'elle permet de séparer les deux substrats l'un de l'autre.

20. Procédé selon les revendications 18 ou 19,
**caractérisé en ce que** l'on met en oeuvre, en tant que couche de séparation, une couche métallique présentant un point de fusion inférieur aux points de fusion desdits substrats.

21. Procédé selon les revendications 18 ou 19,
**caractérisé en ce que** l'on met en oeuvre, en tant que couche de séparation, une couche oxydable qui subira une transformation chimique lorsqu'elle sera soumise à un apport d'oxygène et/ou d'énergie thermique.

22. Procédé selon les revendications 18 ou 19,
**caractérisé en ce que** l'on met en oeuvre, en tant que couche de séparation, une couche de carbone, une couche de diamant, une couche s'apparentant à du diamant ou bien du SiC.

23. Procédé selon l'une des revendications 16 à 22,
**caractérisé en ce que**, suite à la séparation des deux substrats plans l'un de l'autre, ledit substrat plan vitreux (6) subit une finition mécanique destinée à obtenir des passages traversant verticalement ledit substrat plan.

24. Procédé selon la revendication 23,
**caractérisé en ce que** lesdits passages sont remplis avec un matériau conducteur d'électricité.

25. Procédé selon l'une des revendications 2 à 15,
**caractérisé en ce que**, avant de déposer la couche métallique sur ladite zone de surface structurée et faisant saillie, de façon à ce qu'elle se conforme à ladite structure, on dépose une couche protectrice sur ledit substrat plan semi-conducteur (1) afin d'éviter des réactions entre ledit substrat plan semi-conducteur (1) et ladite couche métallique.

26. Procédé selon l'une des revendications 2 à 15 ou 25,
**caractérisé en ce que**, avant de réaliser la liaison entre ladite surface structurée métallisées et ledit substrat plan vitreux (6), on enlève au moins partiellement ladite surface métallisée.

27. Procédé selon l'une des revendications 1 à 26,
**caractérisé en ce que** ledit matériau vitreux et ledit matériau semi-conducteur présentent des coefficients de dilatation thermique presque identiques.

28. Procédé selon l'une des revendications 1 à 27,
**caractérisé en ce que** ledit substrat plan (6) constitué d'un matériau vitreux, est un verre borosilicate.

29. Procédé selon l'une des revendications 1 à 28,
**caractérisé en ce que** ledit substrat plan semi-conducteur (1) est un substrat de silicium.

30. Procédé selon les revendications 25 et 29,
**caractérisé en ce que** l'on dépose, en tant que couche protectrice, du SiO₂ thermique.

31. Procédé selon l'une des revendications 1 à 30,
**caractérisé en ce que** la structuration dudit substrat plan semi-conducteur (1) conduit à des cavités (5) ayant des dimensions structurelles de l'ordre du micromètre ou inférieures à l'ordre du micromètre.

32. Procédé selon l'une des revendications 1 à 31,
**caractérisé en ce que** lesdites cavités (5) présentent un rapport d'aspect (hauteur ou, respectivement, profondeur : largeur) égal à 10 : 1

33. Substrat plan vitreux, fabriqué suivant un procédé selon les revendications 1 à 32,
**caractérisé en ce que** des passages traversent ledit substrat plan vitreux (6) dans un sens perpendiculaire à la surface de ce dernier, du matériau conducteur d'électricité étant prévu en leur sein.

34. Substrat plan vitreux selon la revendication 33,
**caractérisé en ce que** lesdits passages remplis de matériau conducteur d'électricité sont disposés de façon à former un ensemble ordonné.

35. Utilisation du substrat plan selon les revendications 33 ou 34 afin réaliser un contact électrique entre des composants issus des domaines de la microélectronique ou de la micromécanique.

36. Procédé selon l'une des revendications 1 à 15 ou 25 à 32,
**caractérisé en ce que** l'on fabrique un substrat plan semi-conducteur renfermant un matériau vitreux.

37. Substrat plan semi-conducteur, fabriqué avec un procédé selon la revendication 36,
**caractérisé en ce que** ledit substrat plan semi-conducteur (1) est un wafer de silicium qui comporte des zones en matériau vitreux qui traversent ledit wafer de silicium au moins partiellement afin de réaliser une isolation électrique et/ou thermique ou pour des raisons de transparence optique.

38. Substrat plan semi-conducteur selon la revendication 37,
**caractérisé en ce que** lesdites zones en matériau vitreux qui traversent ledit wafer de silicium au moins partiellement, renferment au moins une zone semi-conductrice, et
qu'une couche métallique est prévue au moins entre lesdites zones semi-conductrices renfermées et lesdites zones en matériau vitreux.

39. Substrat plan semi-conducteur selon la revendication 38,
**caractérisé en ce que** ladite zone semi-conductrice renfermée est, des deux côtés, recouverte par une structure d'électrode, ces structures d'électrodes réalisant chacune le contact avec la couche métallique renfermant ladite zone semi-conductrice.
